# EUROPEAN PATENT APPLICATION

(11) **EP 1 102 351 A1**
(43) Date of publication of application: **23.05.2001**
(21) Application number: 00122361.9
(22) Date of filing: 24.10.2000
(51) Int. Cl.: H01R 9/20

(54) **A wire laying plate assembly and a molding process for an insulation plate**

(30) Priority: 15.11.1999 JP 32421599
(71) Applicant: Sumitomo Wiring Systems, Ltd., Yokkaichi-City, Mie, 510-8503 (JP)
(72) Inventor: Nakamura, Masayoshi, 1-14 Nishisuehiro-cho Yokkaichi-ken, Mie (JP)
(74) Representative: Müller-Boré & Partner Patentanwälte

(57) **Abstract**

[Object]

To provide a wire laying plate assembly which can be securely assembled by preventing a molding error of insulating plates.

[Solution]

Bosses 46 to 48 to be crimped for connection project from insulating plates 24 to 26 formed of a synthetic resin. The insulating plates 25 to 27 are formed with boss escaping portions 55 to 57 for accommodating leading ends 49 to 51 of the bosses 46 to 48 formed on different insulating plates 24 to 26 placed one over another. The boss escaping portions 55 to 57 are so formed as to gradually become deeper from their outer peripheries toward their centers. Busbars 28 to 31 are arranged between the insulating plates 24 to 27. The busbars 29 to 31 are formed with insertion holes 52 to 54. The busbars 29 to 31 are secured to the insulating plates 24 to 27 by inserting the bosses 46 to 48 through the insertion holes 52 to 54 and crimping them. In this way, a wire laying plate assembly 19 is assembled.

## Description

The present invention relates to a wire laying plate assembly and to a molding process for molding an insulating plate for use with such a wire laying plate assembly.

A wire laying plate assembly to be accommodated in an electrical connection box is known. This wire laying plate assembly is used to provide branching points of wiring such as a wiring harness.

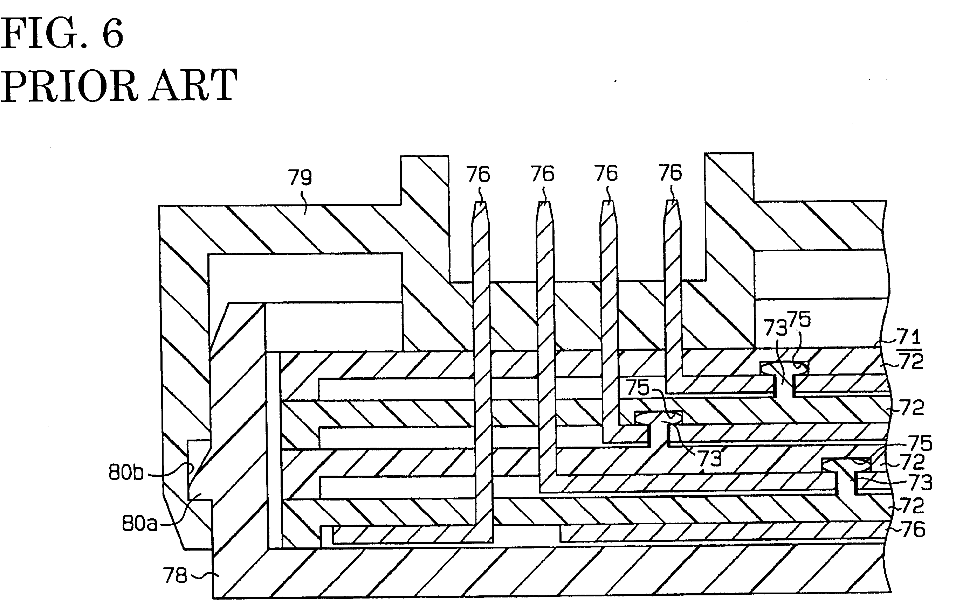

For example, as shown in FIG. 6, insulating plates 72 which are part of a wire laying plate assembly 71 are placed one over another, and busbars 76 are provided between the insulating plates 72. The insulating plates 72 are made of a synthetic resin, and bosses 73 to be crimped for connection project therefrom. Leading ends 74 of the bosses 73 provided on the insulating plates 72 are accommodated in boss escaping portions 75 formed in different insulating plates 72. Further, the busbars 76 are formed with insertion holes 77.

In order to assemble the insulating plates 72 and the busbars 76, the bosses 73 are first inserted through the insertion holes 77 formed in the busbars 76. In this state, the leading ends 74 of the bosses 73 are crimped. As a result, the busbars 76 are secured to the insulating plates 72. The wire laying plate assembly 71 is formed by alternately placing the insulating plates 72 and the busbars 76.

The wire laying plate assembly 71 is accommodated in a lower casing 78. In this state, locking recesses 80b formed in an upper casing 79 are engaged with locking projections 80a provided on the lower casing 78 to consequently fix the upper casing 79 to the lower casing 78.

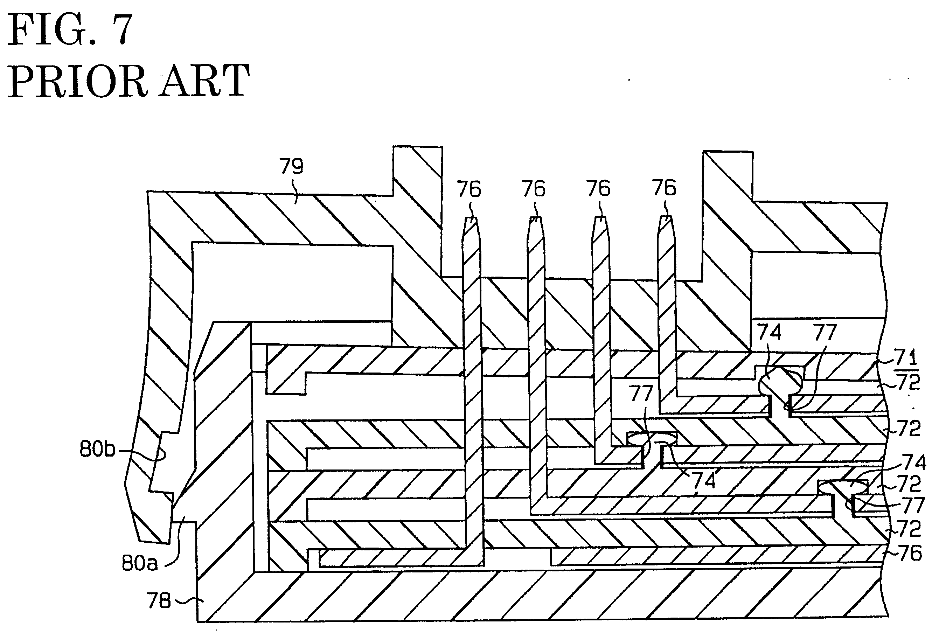

However, in the case that the leading end 74 of the boss 73 is not completely crimped as shown in FIG. 7, a projecting distance thereof is longer than the depth of the boss escaping portion 75, causing a problem of creating a clearance between the insulating plate 72 and the busbar 76. Thus, a portion (tab) of the busbar 76 projecting from the upper surface of the insulating plate 72 is likely to be shorter, which causes a connection error between the busbar 76 and an unillustrated connector. Further, the upper casing 79 cannot be fitted to the lower casing 78 using the locking projections 80a and the locking recesses 80b. In order to solve such problems, there has been a tendency for deepening the boss escaping portions 75.

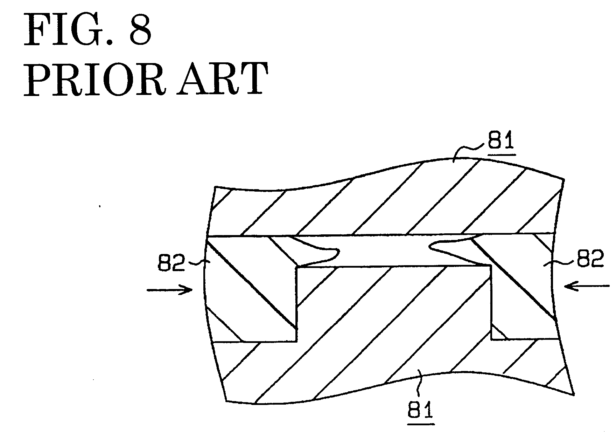

However, if an attempt is made to deepen the boss escaping portion 75, when the insulating plate 72 is formed by pouring a resin 82 into a mold 81, the resin 82 may not be completely filled in the mold 81 as shown in FIG. 8. Thus, a short shot occurs at a portion which is supposed to become the bottom of the boss escaping portion 75, resulting in a molding error of the insulating plate 72. It has not been possible to ensure a sufficient depth of the boss escaping portion 75 for the above reason.

Further, since the thickness of the busbars 76 is smaller than a spacing between the insulating plates 72, clearances are formed between adjacent insulating plates 72 regardless of the crimped states of the leading ends 74 of the bosses 73. Such clearances cause the insulating plates 72 and the busbars 76 to shake with respect to each other, thereby creating a noise.

The present invention was developed in view of the above problems, and an object thereof is to provide a wire laying plate assembly which can be securely assembled by preventing a molding error of insulating plates and to provide a molding process for molding an insulating plate for use with such a wire laying plate assembly.

This object is solved according to the invention by a wire laying plate assembly according to claim 1 and by a molding process according to claim 10. Preferred embodiments of the invention are subject of the dependent claims.

According to the invention, there is provided a wire laying plate assembly in which one or more bosses are formed to project from one or more insulating plate, a corresponding number of boss escaping portions for accommodating leading ends of the bosses are formed in different insulating plates, the bosses being insertable through insertion holes formed in busbars located substantially between adjacent insulating plates and provided to secure the busbars to the insulating plates, thereby assembling the insulating plates and the busbars, wherein each boss escaping portion is so formed as to gradually become deeper toward its center from its outer periphery.

According to a preferred embodiment of the invention, the one or more insulating plates are resin molded products.

Preferably, the different insulating plates are placed substantially on the former insulating plates having the busbars substantially arranged therebetween.

Further preferably, the bosses are crimped or deformed to secure the busbars to the insulating plates.

According to a further preferred embodiment, there is provided a wire laying plate assembly in which bosses to be crimped or deformed or flattened or inserted for connection are formed to project from insulating plates which are resin molded products, boss escaping portions for accommodating leading ends of the bosses are formed in different insulating plates placed on the former insulating plates, the bosses are inserted through insertion holes formed in busbars located between adjacent insulating plates and crimped to secure the busbars to the insulating plates, thereby assembling the insulating plates and the busbars, wherein each boss escaping portion is so formed as to gradually become deeper toward its center from its outer periphery.

Accordingly, the boss escaping portions are so formed as to gradually become deeper toward their centers from their outer peripheries. Thus, even if deep boss escaping portions are formed, a resin is completely fitted at the bottom portions of the boss escaping portions, thereby preventing an occurrence of a short shot during molding. Therefore, the wire laying plate assembly can be securely assembled by preventing a molding error of the insulating plates.

Preferably, a tapered surface is formed at the outer periphery of the bottom surface of each boss escaping portion.

Accordingly, since the tapered surfaces are formed at the outer peripheries of the bottom surfaces of the boss escaping portions, an occurrence of a short shot can be prevented while ensuring a sufficient depth for the boss escaping portions. Thus, the leading ends of the bosses are securely fitted in the boss escaping portions, and the insulating plates are held in close contact with each other. Therefore, the wire laying plate assembly can be more securely assembled.

Further preferably, the insulating plates are formed with recesses for at least partly accommodating the busbars each preferably having a terminal piece at one portion thereof.

Most preferably, the depth of the recesses is smaller than or substantially equal to the thickness of the busbars.

According to a further preferred embodiment, the insulating plates are formed with recesses for accommodating the busbars each having a terminal piece at one portion thereof, and the depth of the recesses and the thickness of the busbars are equal to each other.

Accordingly, since the depth of the recesses and the thickness of the busbars are equal to each other, the busbars and the insulating plates are held in close contact with each other. Thus, the wire laying plate assembly can be securely assembled. Further, generation of a noise caused by shaking of the insulating plates and the busbars with respect to each other can be prevented.

Further preferably, the diameter of the leading ends of the bosses is smaller than or substantially equal to the inner diameter of the boss escaping portions.

Most preferably, a thickness of central bottom portions of the boss escaping portions is about 1/3 of that of the insulating plates, and/or a thickness of the peripheral bottom portions thereof is about 1/3 to 2/3 of that of the insulating plates.

According to the invention, there is further provided a molding process for molding an insulating plate for use with a wire laying plate assembly according to the invention or an embodiment thereof, comprising the following steps:
introducing a melted resin into the mold having a projection projecting from an inner surface thereof, wherein the resin is introduced from a side portion toward a center portion of the projection along a tapered portion inside the mold;
substantially curing the resin inside the mold; and
opening the mold for withdrawing the mold insulation plate.

These and other objects, features and advantages of the present invention will become apparent upon reading of the following detailed description of preferred embodiments and accompanying drawings. It should be understood that even though embodiments are separately described, single features thereof may be combined to additional embodiments.
FIG. 1 is a section showing an electrical connection box accommodating a wire laying plate assembly according to one embodiment,
FIG. 2 is a section showing an essential portion of the electrical connection box,
FIGS. 3(a) and 3(b) are sections showing a molding process of an insulating plate,
FIG. 4 is a section showing an essential portion of an electrical connection box according to another embodiment,
FIG. 5 is a section showing an essential portion of an electrical connection box according to still another embodiment,
FIG. 6 is a section showing a prior art electrical connection box,
FIG. 7 is a section showing a problem of the prior art electrical connection box, and
FIG. 8 is a section showing a problem when a prior art insulating plate is molded.

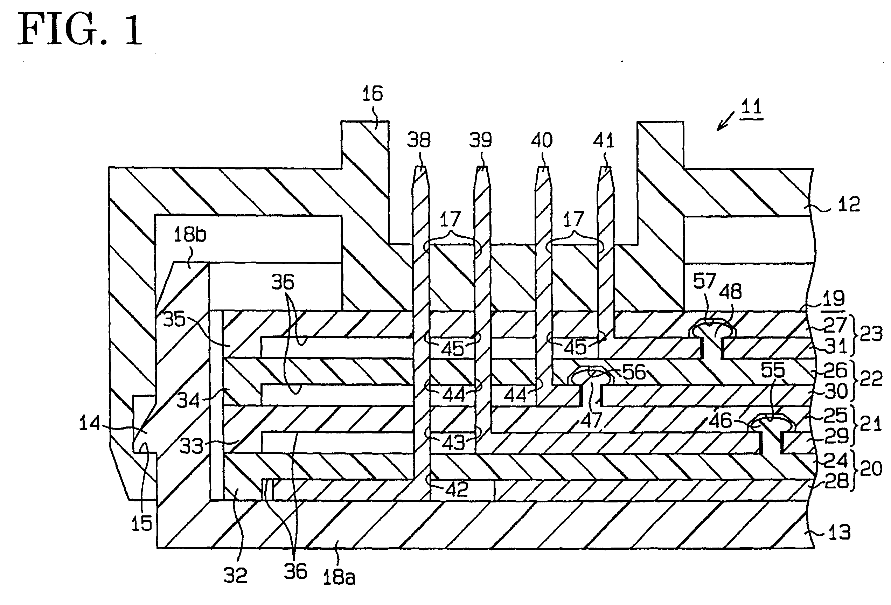

Hereinafter, an electrical connection box including a wire laying plate assembly according to one embodiment of the invention is described with reference to FIGS. 1 to 3.

An electrical connection box is made e.g. of a synthetic resin and comprised of upper or first and lower or second casings 12, 13 as shown in FIG. 1. The upper and lower casings 12, 13 are or can be locked into each other by the engagement of locking projections 14 and locking recesses 15 which are preferably provided as parts of surrounding walls of the upper and lower casings 12, 13.

A connector housing or receptacle 16 preferably in the form of a substantially rectangular tube is formed or provided on the upper surface of the upper casing 12. A plurality of tab insertion holes 17 are formed in the bottom wall of the connector housing 16. The lower casing 13 is comprised of a bottom portion 18a and a substantially surrounding wall 18b, and a wire laying plate assembly 19 is or can be at least partly accommodated in the lower casing 13. The wire laying plate assembly 19 is such that a plurality of wire laying plates 20, 21, 22, 23 are or can be placed substantially one over another. The inner surface of the bottom portion 18a at least partly supports the bottommost wire laying plate 20.

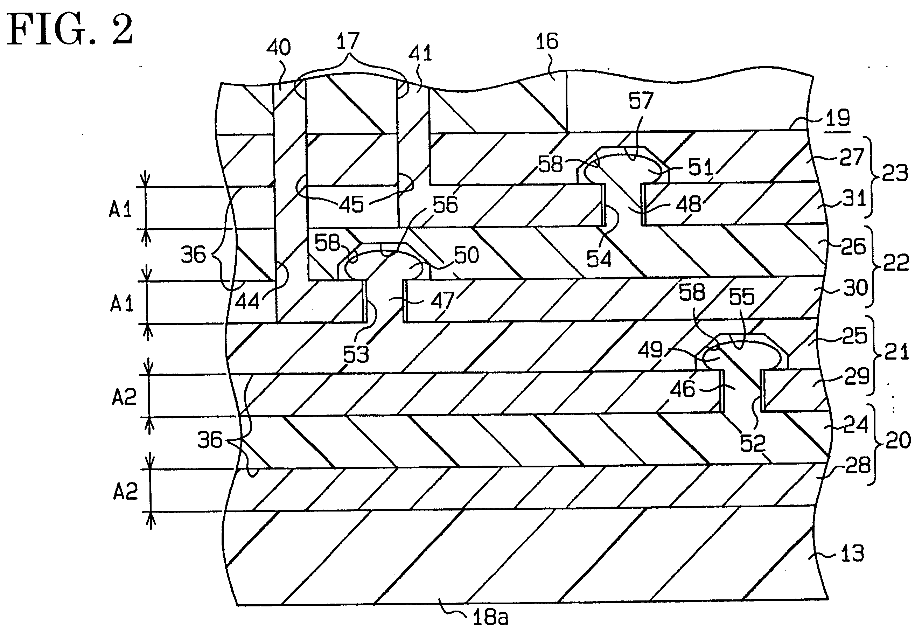

As shown in FIGS. 1 and 2, the wire laying plates 20 to 23 are comprised of insulating plates 24, 25, 26, 27 made e.g. of a synthetic resin material and busbars 28, 29, 30, 31 made e.g. of metal plates provided on the lower surfaces of the insulating plates 24 to 27, respectively.

Insulating ribs 32, 33, 34, 35 project from the lower surface of the outer peripheries of the insulating plates 24 to 27. Recesses 36 are formed or defined on the lower surfaces of the insulating plates 24 to 27 preferably by these insulating ribs 32 to 35. Busbars 28 to 31 are or can be at least partly accommodated in the respective recesses 36. As shown in FIG. 2, a depth A1 of the recesses 36 is preferably set substantially equal to a thickness A2 of the busbars 28 to 31. Therefore, the insulating plates 24 to 27 and the busbars 28 to 31 are held substantially in close contact with each other.

Tabs 38, 39, 40, 41 as terminals are bent at an angle different from 0° and 90° and comprised therebetween, preferably substantially normally or upward in specified (predetermined or predeterminable) positions of the busbars 28 to 31. The lengths of a plurality of tabs 38 to 41 are preferably set such that the leading ends thereof are at the substantially same height when the wire laying plates 20 to 23 are placed substantially one over another. Thus, the tab 41 of the uppermost busbar 31 is shortest and the tab 38 of the bottommost busbar 28 is longest. These tabs 38 to 41 are or can be inserted through a plurality of tab insertion holes 17 formed in the connector housing 16.

A through hole 42 is formed in a position of the insulating plate 24 substantially corresponding to the tab 38. A plurality of through holes 43 are formed in positions of the insulating plate 25 substantially corresponding to the tabs 38, 39. A plurality of through holes 44 are formed in positions of the insulating plate 26 substantially corresponding to the tabs 38 to 40. A plurality of through holes 45 are formed in positions of the insulating plate 27 substantially corresponding to the tabs 38 to 41.

Bosses 46, 47, 48 to be e.g. crimped or inserted or flattened or deformed for connection project from the upper surfaces of the insulating plates 24 to 26. Leading ends 49, 50, 51 of the bosses 46 to 48 are crimped or inserted or flattened or deformed. The busbar 29 is formed with an insertion hole 52 substantially corresponding to the boss 46, and a boss escaping (or accommodating) portion 55 is so formed in the recess 36 of the insulating plate 25 as to substantially face the leading end 49 of the boss 46. The busbar 29 is secured to the insulating plate 25 by inserting the boss 46 through the insertion hole 52 and crimping or inserted or flattened or deformed the leading end 49.

Further, the busbar 30 is formed with an insertion hole 53 substantially corresponding to the boss 47, and a boss escaping (or accommodating) portion 56 is so formed in the recess 36 of the insulating plate 26 as to substantially face the leading end 50 of the boss 47. The busbar 30 is secured to the insulating plate 26 by inserting the boss 47 through the insertion hole 53 and crimping or inserted or flattened or deformed the leading end 50.

Furthermore, the busbar 31 is formed with an insertion hole 54 corresponding to the boss 48, and a boss escaping (or accommodating) portion 57 is so formed in the recess 36 of the insulating plate 27 as to substantially face the leading end 51 of the boss 48. The busbar 31 is secured to the insulating plate 27 by inserting the boss 48 through the insertion hole 54 and crimping or inserted or flattened or deformed the leading end 51.

These boss escaping portions 55 to 57 are so formed as to gradually become deeper toward their centers from their. outer peripheries. In other words, the depth of the boss escaping portions 55 to 57 with respect to an edge portion thereof (i.e. a portion of the insulating plate 25-27 adjacent to the boss escaping portions 55-57) is increasing when moving away from the edge portions towards the center portion of the boss escaping portions 55 to 57 so as to have a concave shape. Accordingly, the inner walls of the boss escaping portions 55 to 57 are converging towards each other in such a direction so as to open towards the corresponding boss 46 to 48. Thus, a bottom portion of each boss escaping portion gradually become thinner toward its center from its outer periphery. The width of the boss escaping portions 55 to 57 is substantially larger than the outer diameter of the bosses 46 to 48, and the depth thereof is larger than the height of the leading ends 49 to 51. Slanted or converging surfaces 58 are formed or defined on the outer peripheries of the bottom surfaces of the boss escaping portions 55 to 57. In the insulating plates 25 to 27, the thickness of central bottom portions of the boss escaping portions 55 to 57 is preferably about 1/3 of that of the insulating plates 25 to 27, and the thickness of the peripheral bottom portions thereof is preferably about 1/3 to 2/3 of that of the insulating plates 25 to 27. The slanted surfaces 58 are inclined with respect to the bottom surfaces of the boss escaping portions 55 to 57 by an angle different from 0° or 90° and comprised therebetween, preferably by about 45°. For these reasons, e.g. a synthetic resin is completely filled when the insulating plates 25 to 27 are to be molded, preventing an occurrence of a short shot during molding. Further, the leading ends 49 to 51 of the bosses 46 to 48 are or can be securely fitted or inserted in the boss escaping portions 55 to 57, and the insulating plates 24 to 27 are or can be held in substantially close contact with each other.

Accordingly, as shown in FIG. 1, the respective tabs 38 to 41 are inserted into the corresponding through holes 42 to 45, and the bosses 46 to 48 are fitted in the corresponding boss escaping portions 55 to 57. Thus, the respective layers of the wire laying plates 20 to 23 are accommodated in the lower casing 13 while being placed substantially one over another.

Next, a molding process of the insulating plates 25 to 27 is described in detail.

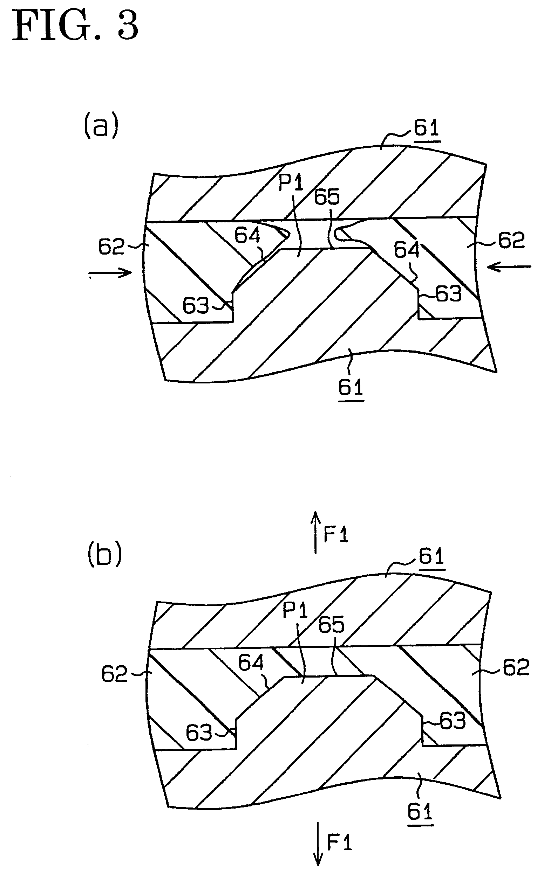

As shown in FIGS. 3(a) and 3(b), a projection P1 projects from the inner surface of a mold 61. In order to mold the insulating plates 25 to 27, a melted resin 62 is first poured into the mold 61 as shown in FIG. 3(a). The resin 62 is smoothly poured from a side portion 63 toward a center portion 65 of the projection 61 along a tapered portion 64 inside the mold 61. The mold 61 substantially filled with the resin 62 as shown in FIG. 3(b) is left until the resin 62 is substantially cured. After the resin 62 is substantially cured, the mold 61 is opened in directions of arrows F1. As a result, the insulating plates 25 to 27 are formed of the resin 62.

Accordingly, this embodiment has the following effects.
(1) Since the boss escaping portions 55 to 57 are so formed as to gradually become deeper from their outer peripheries toward their centers, the synthetic resin is completely filled in the mold during the molding of the insulating plates 25 to 27, thereby preventing an occurrence of a short shot. This can prevent a molding error of the insulating plates 25 to 27. Accordingly, the wire laying plates 20 to 23 in the respective layers can be held in substantially close contact with each other, with the result that the wire laying plate assembly 19 can be securely assembled. Since at least part of the wire laying plate assembly 19 is securely accommodated in the lower casing 13, the upper casing 12 can be securely mounted on the lower casing 13 by engaging the locking projections 14 and the locking recesses 15.
(2) Since the slanted surfaces 58 are formed at the outer peripheries of the bottom surfaces of the boss escaping portions 55 to 57, an occurrence of a short shot is prevented while ensuring a sufficient depth for the boss escaping portions 55 to 57. Accordingly, the leading ends 49 to 51 of the bosses 46 to 48 are securely fitted in the boss escaping portions 55 to 57 and the insulating plates 24 to 27 are held in close contact with each other. Thus, the wire laying plate assembly 19 can be securely assembled. Further, since the areas of the thin portions of the insulating plates 25 to 27 are decreased by the presence of the slanted surfaces 58, a sufficient strength can be secured for the insulating plates 25 to 27.
(3) Since the depth A1 of the recesses 36 and the thickness A2 of the busbars 28 to 31 are substantially equal, the busbars 28 to 31 and the insulating plates 24 to 27 are held in close contact with each other in the assembled wire laying plate assembly 19, creating no clearance therebetween. Thus, the wire laying plate assembly 19 can be securely assembled. Further, generation of the noise caused by shaking of the insulating plates 24 to 27 and the busbars 28 to 31 can be prevented. Furthermore, the lengths of the tabs 38 to 41 projecting from the connector housing 16 preferably are constantly stable. This makes it unnecessary to provide a margin for the lengths of the tabs 38 to 41. Therefore, a connector can be securely connected even if the tabs 38 to 41 are shortened.

The embodiment of the present invention may be modified as follows.

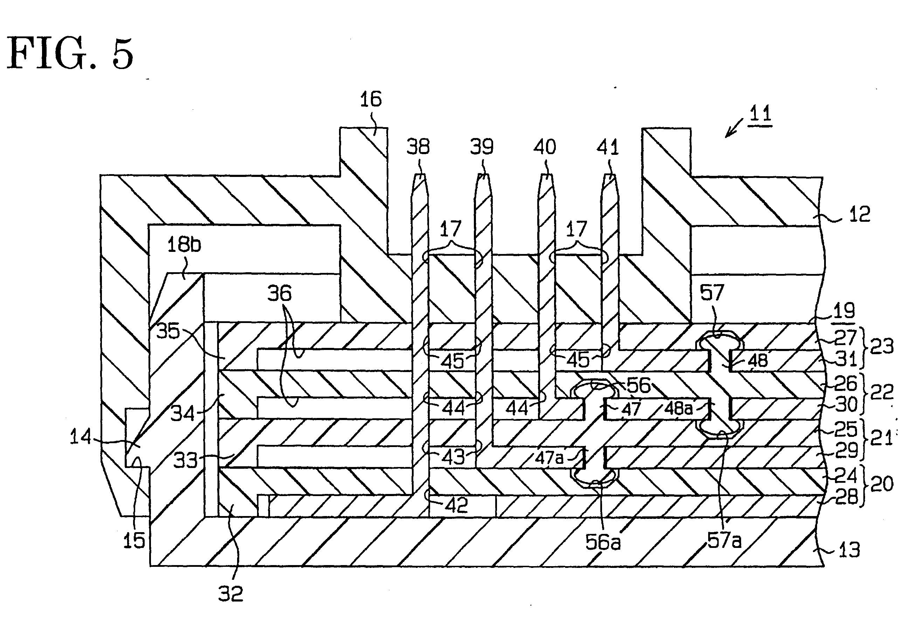

In the foregoing embodiment, the bosses 46 to 48 are formed on the upper surfaces of the insulating plates 24 to 26 and the boss escaping portions 55 to 57 are formed in the lower surfaces of the insulating plates 25 to 27. However, as shown in FIG. 5, bosses 47, 47a, 48, 48a may be formed to project from the upper and lower surfaces of the insulating plates 25, 26, and boss escaping portions 56a, 57a may be formed in the upper surfaces of the insulating plates 24, 25 while boss escaping portions 56, 57 being formed in the lower surfaces of the insulating plates 26, 27.

Although the depth A1 of the recesses 36 is substantially equal to the thickness A2 of the busbars 28 to 31 in the foregoing embodiment, it may be shorter than the thickness A2. Then, the insulating ribs 32 to 35 can be shortened. Therefore, production costs for the insulating plates 24 to 27 can be reduced.

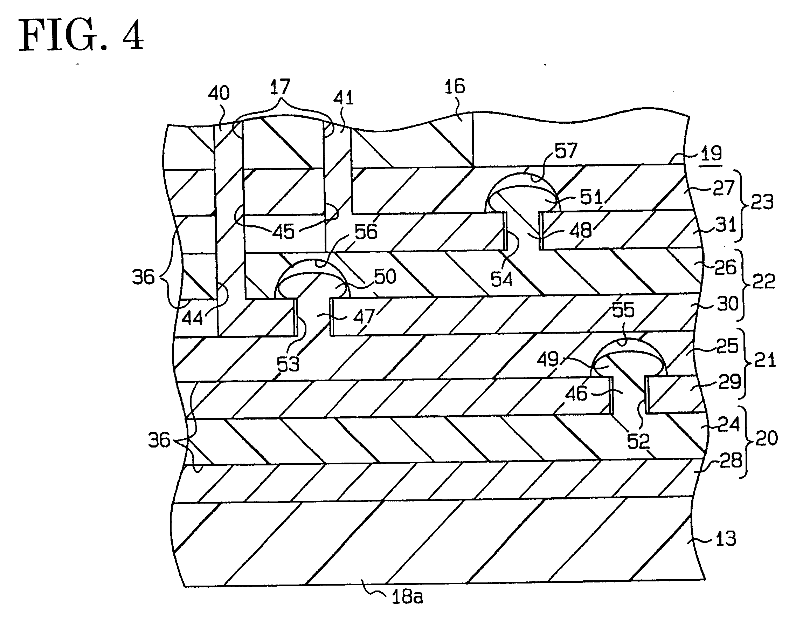

In the foregoing embodiment, the boss escaping portions 55 to 57 are so formed as to gradually become deeper toward their centers from their outer peripheries, and the tapered surfaces 58 are formed at the outer peripheries of the bottom surfaces of the boss escaping portions 55 to 57 so that the boss escaping portions 55 to 57 have a substantially conical or frustoconical shape or shape of a truncated cone. However, as shown in FIG. 4, the boss escaping portions 55 to 57 may be formed to have a semicircular cross section. Alternatively, the boss escaping portions 55 to 57 may be formed to have a parabolic or semielliptic or rounded or concave cross section. It is to be understood that the shape of the boss escaping portions 55 to 57 may be either rotationally symmetric or alternatively elongated so that a corrispondingly elongated center portion may be regarded as the "center" of the boss escaping portions 55 to 57. The boss escaping portions 55 to 57 may be either bottomed or truncated, therefore forming a recess having rounded or slanted or converging portions 58 and a bottom portion having substantially equal depth with respect to the edge portion or completely concave or rounded or converging.

Although the diameter of the leading ends 49 to 51 of the bosses 46 to 48 is smaller than the inner diameter of the boss escaping portions 55 to 57 in the foregoing embodiment, it may be substantially equal to the inner diameter of the boss escaping portions 55 to 57. Then, the insulating plates 24 to 27 are prevented from shaking with respect to each other.

Accordingly, the foregoing embodiment(s) is/are based on the following technical concepts.
(1) A wire laying plate assembly in which bosses to be crimped or deformed or inserted or flattened for connection are formed to project from insulating plates which are e.g. resin molded products, boss escaping portions for accommodating leading ends of the bosses are formed in different insulating plates placed on the former insulating plates, the bosses are inserted through insertion holes formed in busbars located between adjacent insulating plates and crimped to secure the busbars to the insulating plates, thereby assembling the insulating plates and the busbars, wherein a bottom portion of each boss escaping portion gradually become thinner toward its center from its outer periphery.
(2) The diameter of the leading ends of the bosses is preferably smaller than the inner diameter of the boss escaping portions.

As described in detail above, the wire laying plate assembly can be securely assembled by preventing a molding error of the insulating plates.

Moreover, the wire laying plate assembly can be more securely assembled.

Furthermore, the wire laying plate assembly can be securely assembled, and generation of a noise caused by shaking of the busbars can be prevented.

### LIST OF REFERENCE NUMERALS

- 19: wire laying plate assembly
- 24, 25, 26, 27: insulating plate
- 28, 29, 30, 31: busbar
- 36: recess
- 38, 39, 40, 41: tabs as terminals
- 46, 47, 48: boss,
- 49, 50, 51: leading end
- 52, 53, 54: insertion hole
- 55, 56, 57: boss escaping portion
- 58: slanted or converging surface

## Claims

1. A wire laying plate assembly in which one or more bosses (46-48) are formed to project from one or more insulating plates (25-27), a corresponding number of boss escaping portions (55-57; 56a, 57a) for accommodating leading ends (49-51) of the bosses (46-48) are formed in different insulating plates (24-26), the bosses (46-48) being insertable through insertion holes (52-54) formed in busbars (29-31) located substantially between adjacent insulating plates (25-27) and provided to secure the busbars (29-31) to the insulating plates (25-27), thereby assembling the insulating plates (24-26) and the busbars (29-31), wherein each boss escaping portion (55-57; 56a, 57a) is so formed as to gradually become deeper toward its center from its outer periphery.

2. A wire laying plate assembly according to claim 1, wherein the one or more insulating plates (25-27) are resin molded products.

3. A wire laying plate assembly according to one or more of the preceding claims, wherein the different insulating plates (24-26) are placed substantially on the former insulating plates (25-27) having the busbars (29-31) substantially arranged therebetween.

4. A wire laying plate assembly according to one or more of the preceding claims, wherein the bosses (46-48) are crimped or deformed to secure the busbars (29-31) to the insulating plates (25-27).

5. A wire laying plate assembly according to one or more of the preceding claims, wherein a tapered surface (58) is formed at the outer periphery of the bottom surface of each boss escaping portion (55-57; 56a, 57a).

6. A wire laying plate assembly according to one or more of the preceding claims, wherein the insulating plates (24-27) are formed with recesses (36) for at least partly accommodating the busbars (29-31) each preferably having a terminal piece at one portion thereof.

7. A wire laying plate assembly according to claim 6, wherein the depth (A1) of the recesses (36) is smaller than or substantially equal to the thickness (A2) of the busbars (29-31).

8. A wire laying plate assembly according to one or more of the preceding claims, wherein a diameter of the leading ends (49-51) of the bosses (46-48) is smaller than or substantially equal to a inner diameter of the boss escaping portions (55-57).

9. A wire laying plate assembly according to one or more of the preceding claims, wherein a thickness of central bottom portions of the boss escaping portions (55-57) is about 1/3 of that of the insulating plates (25-27), and/or a thickness of the peripheral bottom portions thereof is about 1/3 to 2/3 of that of the insulating plates (25-27).

10. A molding process for molding an insulating plate (25-27) for use with a wire laying plate assembly according to one or more of the preceding claims, comprising the following steps:
introducing a melted resin (62) into the mold (61) having a projection (P1) projecting from an inner surface thereof, wherein the resin (62) is introduced from a side portion (63) toward a center portion (65) of the projection (62) along a tapered portion (64) inside the mold (61);
substantially curing the resin (62) inside the mold (61); and
opening the mold (61) for withdrawing the mold insulation plate (25-27).
